# FASCICULE DE BREVET EUROPEEN

(11) **EP 2 209 928 B1**
(45) Date de publication et mention de la délivrance du brevet: **04.01.2017**
(21) Numéro de dépôt: 08868936.9
(22) Date de dépôt: 20.10.2008
(51) Int. Cl.: C23C 16/26, C23C 16/515

(54) **PROCEDE DE REALISATION DE REVETEMENT EN CARBONE AMORPHE HYDROGENE**
VERFAHREN ZUR VERWIRKLICHUNG EINER SCHICHT AUS WASSERSTOFFHALTIGEM, AMORPHEM KOHLENSTOFF
METHOD OF PRODUCING A HYDROGENATED AMORPHOUS CARBON COATING

(30) Priorité: 23.10.2007 FR 0707422
(43) Date de publication de la demande: 28.07.2010
(73) Titulaire: Commissariat à l'Énergie Atomique et aux Énergies Alternatives, 75015 Paris (FR); Centre National de la Recherche Scientifique, 75016 Paris (FR)
(72) Inventeur: CHOUQUET, Caroline, F-56530 Gestel (FR); DUCROS, Cédric, F-38690 Bevenais (FR); SANCHETTE, Frédéric, F-38620 Montferrat (FR)
(74) Mandataire: Gevers & Orès
(86) Numéro de dépôt international: PCT/FR2008/001472
(87) Numéro de publication internationale: WO 2009/083673

(56) Documents cités:
- QI J ET AL: "Mechanical properties of a-C:H multilayer films" DIAMOND AND RELATED MATERIALS, vol. 10, no. 9-10, 1 septembre 2001 (2001-09-01), pages 1833-1838, XP004321131 ELSEVIER SCIENCE PUBLISHERS, AMSTERDAM [NL] ISSN: 0925-9635
- LU ET AL: "Micromechanical properties of hydrogenated diamond-like carbon multilayers" SURFACE AND COATINGS TECHNOLOGY, vol. 201, no. 3-4, 5 octobre 2006 (2006-10-05), pages 1679-1684, XP005646981 ELSEVIER, AMSTERDAM [NL] ISSN: 0257-8972
- VOEVODIN A A ET AL: "Architecture of multilayer nanocomposite coatings with super-hard diamond-like carbon layers for wear protection at high contact loads" WEAR, vol. 203-204, 1 mars 1997 (1997-03-01), pages 516-527, XP000997396 ELSEVIER SEQUOIA, LAUSANNE [CH]

## Description

L'invention concerne un revêtement en carbone amorphe hydrogéné ainsi qu'un procédé pour sa réalisation. Elle concerne également les dispositifs comprenant un tel revêtement.

Les phénomènes de frottement et d'usure dans les ensembles mécaniques sont à l'origine de pertes d'énergie considérables.

C'est pourquoi, on a beaucoup étudié depuis plusieurs années des revêtements ayant des propriétés mécaniques en termes de résistance à l'usure, de dureté et de ténacité importantes.

Les revêtements les plus rencontrés actuellement sont des revêtements en nitrure tels que les nitrures de titane (TiN) et les nitrures de chrome (CrN), les carbures tels que les carbures de titane (TiC), les carbures de chrome (CrC), les carbures de tungstène (W₂C) et les carbures de tungstène/carbone (WC/C), les oxydes tels que l'alumine, les dépôts à base de molybdène tel que le sulfure de molybdène (MoS₂), ainsi que toute la famille des revêtements à base de carbone appelés Diamond Like Carbon (DLC).

Les DLC, de part leur combinaison exceptionnelle de propriétés, se sont révélés d'excellents revêtements pour des pièces soumises à des problèmes de frottement et d'usure importants, telles que des pièces de moteur.

Les revêtements DLC sont des revêtements à base de carbone. En fonction de la technique d'élaboration, ils possèdent, en effet, non seulement des duretés élevées mais également de faibles coefficients de frottement et taux d'usure.

Certains de ces revêtements sont composés d'une monocouche mais leur principal inconvénient est leur niveau de contraintes internes élevées, de l'ordre de quelques GPa, qui limitent bien souvent leur épaisseur à 2 micromètres, ce qui est insuffisant dans certaines applications.

C'est pourquoi la recherche se tourne actuellement vers l'utilisation de DLC dopés ou encore de systèmes multicouches à base de DLC.

En effet, les multicouches à base de DLC semblent permettre de limiter les contraintes internes et d'atteindre ainsi des épaisseurs de revêtement beaucoup plus importantes tout en conservant des propriétés mécaniques intéressantes.

Deux principaux systèmes multicouches à base de carbone amorphe hydrogéné, communément appelé a-C:H, apparaissent dans la bibliographie :
1) les empilements de deux couches de a-C:H différentes l'une étant dite dure et l'autre dite molle, come décrit par Gupta et al. dans "Tribological behavior of plasma-enhanced CVD a-C:H films", Tribology International 37, (2004), 1031-1038,
   ou par Qi J et al. dans "Mechanical properties of a-C:H multilayer films", Diamond and Related Materials 10 (2001), 1833 - 1838,
2) les empilements du type a-C:H/a-SiC:H.

Cependant, ces empilements multicouches, de part la présence de matériaux différents, présentent des propriétés tribologiques et mécaniques (dureté) inférieures à celles des monocouches en a-C:H.

L'invention vise à pallier les problèmes de l'art antérieur en proposant un revêtement multicouches à base de carbone amorphe hydrogéné ayant des propriétés mécaniques, en termes de dureté, de coefficient de frottement et de taux d'usure, équivalentes à celles d'un dépôt monocouche ou multicouches en carbone amorphe hydrogéné classique, mais présentant des contraintes résiduelles inférieures, ce qui permet d'augmenter l'épaisseur totale du revêtement jusqu'à 10 micromètres.

A cet effet, l'invention propose un revêtement en carbone amorphe hydrogéné caractérisé en ce qu'il comprend au moins deux couches superposées l'une sur autre en carbone amorphe hydrogéné ayant des compositions chimiques et des caractéristiques physiques et mécaniques identiques, et des épaisseurs identiques ou différentes.

De préférence, chacune desdites couches en carbone hydrogéné a une épaisseur inférieure ou égale à 500 nm.

De préférence, le revêtement de l'invention a une épaisseur supérieure ou égale à 1,5 micromètres, le plus préférablement supérieure ou égale à 2 micromètres.

Dans un mode de réalisation préféré, le revêtement de l'invention comprend plus de dix couches par micromètre d'épaisseur de revêtement.

L'invention propose également un procédé de dépôt du revêtement de l'invention, sur au moins une surface d'un substrat comprenant les étapes de dépôt par dépôt chimique en phase vapeur assisté par plasma d'une première couche en carbone amorphe hydrogéné, pendant une durée t₁, d'arrêt du générateur de plasma pendant une durée t, de dépôt d'une seconde couche sur la couche obtenue précédemment par remise en route du générateur de plasma dans les mêmes conditions de puissance, de température, de pression et d'atmosphère qu'à l'étape de dépôt de la première couche, pendant une durée t₂ qui est identique ou différente de la durée t₁ de l'étape de dépôt de la première couche, et , optionnellement, répétition au moins une fois des étapes d'arrêt du générateur et de dépôt d'une nouvelle couche jusqu'à obtenir l'épaisseur voulue du revêtement.

De préférence, la durée t d'arrêt du générateur est inférieure aux durées des étapes de dépôt.

De préférence, pendant l'étape d'arrêt du générateur, on réalise un décapage de la surface supérieure de la couche obtenue à l'étape précédente.

De préférence, ce décapage est réalisé par bombardement ionique sous gaz neutre de ladite surface supérieure.

Dans le procédé de l'invention, les durées t₁, t₂ des étapes de dépôt sont telles que l'épaisseur de chaque couche déposée est inférieure ou égale à 500 nm.

De préférence, dans le procédé de l'invention, les étapes d'arrêt du générateur et de dépôt d'une nouvelle couche sont répétées jusqu'à obtenir une épaisseur finale du revêtement de préférence supérieure ou égale à 1,5 micromètres, plus préférablement supérieure ou égale à 2 micromètres.

Egalement de préférence, le procédé de l'invention comprend de plus, avant l'étape de dépôt de la première couche, une étape de dépôt d'une couche en SiC:H sur la surface du substrat à revêtir.

L'invention propose encore un dispositif comprenant un revêtement selon l'invention ou obtenu par le procédé selon l'invention.

L'invention sera mieux comprise et d'autres avantages et caractéristiques de celle-ci apparaitront plus clairement à la lecture de la description qui suit et qui est faite en référence aux figures dans lesquelles :
- la figure 1 représente une coupe schématique d'un mode de réalisation du revêtement selon l'invention déposé sur au moins une surface d'un substrat, et
- la figure 2 représente schématiquement une enceinte de dépôt chimique en phase vapeur assisté par plasma.

L'invention consiste à déposer sur un support plastique, métallique ou céramique un revêtement multicouches du type carbone amorphe hydrogéné/ carbone amorphe hydrogéné, noté dans ce qui suit a-C:H/a-C:H, ayant des propriétés mécaniques en termes de dureté, de coefficient de frottement et d'usure, notamment, équivalentes à celles d'un dépôt a-C:H classique monocouche, mais présentant des contraintes résiduelles inférieures.

Le revêtement selon l'invention est donc constitué d'un empilement de couches de même composition chimique présentant des propriétés mécaniques et des caractéristiques physiques strictement identiques, mais des interfaces sont créées entre les différentes couches, ce qui permet de réduire les contraintes résiduelles du revêtement.

Le revêtement selon l'invention est dépourvu des fissurations, qui engendrent l'effeuillage du revêtement, présentes dans les revêtements monocouches de l'art antérieur, lorsqu'il est soumis à des contraintes résiduelles, tout en ayant des épaisseurs supérieures ou égales à 1,5 à 2 micromètres.

De plus, le revêtement de l'invention est composé de couches ayant toutes les mêmes propriétés physicochimiques du fait des conditions de dépôt strictement identiques (à l'exception de la durée de dépôt) utilisées pour le dépôt de chaque couche, ce qui permet d'obtenir un dépôt ayant une bonne durée de vie, en utilisation, du revêtement selon l'invention.

De plus, dans l'art antérieur, pour obtenir des caractéristiques physicochimiques intéressantes, on a, jusqu'à l'invention, cherché à faire varier la composition chimique et/ou la dureté ou l'élasticité des couches composant le revêtement multicouches, d'une couche à l'autre.

Les couches constituant le revêtement de l'invention ont certes la même composition chimique et des propriétés mécaniques et des caractéristiques physiques strictement identiques, mais elle peuvent avoir des épaisseurs identiques ou différentes.

Dans tous les cas toutes les couches de revêtement multicouches selon l'invention ont de préférence des épaisseurs inférieures à 500 nm.

Le revêtement de l'invention comprend donc au moins deux couches, mais pour obtenir des épaisseurs de revêtement supérieures ou égales à 2 micromètres, le revêtement de l'invention comprendra autant de couches que nécessaire.

Par exemple, pour obtenir une épaisseur de revêtement de 2 micromètres, 80 couches de 25 nm seront formées.

Une telle épaisseur garantit une meilleure durée de vie de la pièce revêtue.

Ainsi, le revêtement de l'invention peut être obtenu par empilement d'autant de couches identiques, en dehors éventuellement de leur épaisseur, en a-C:H que nécessaire pour atteindre des épaisseurs de revêtement de jusqu'à 10 micromètres inclus, tout en conservant des propriétés mécaniques au moins équivalentes, si ce n'est supérieures, à un revêtement monocouche de l'art antérieur.

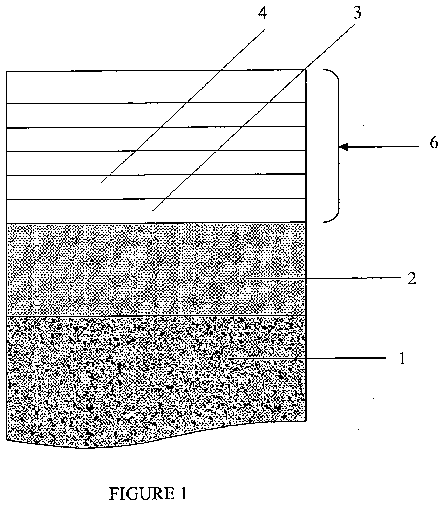

L'architecture d'un premier mode de réalisation du revêtement de l'invention est présentée schématiquement en figure 1.

Comme on le voit en figure 1, le revêtement multicouches selon l'invention, noté 6 en figure 1, est constitué d'un empilement de couches identiques, y compris en épaisseur, notées 3, 4, 5 en figure 1.

Ces couches sont déposées sur un substrat, noté 1 en figure 1.

Mais d'autres architectures du revêtement de l'invention existent.

Ces architectures sont des architectures dans lesquelles les couches empilées formant le revêtement de l'invention n'ont pas toutes la même épaisseur.

Par exemple, pour améliorer encore les qualités tribologiques et mécaniques du revêtement, il est avantageux de déposer d'abord des couches fines puis des couches plus épaisses.

Ainsi, dans un second mode de réalisation préféré de l'invention, pour un revêtement ayant une épaisseur finale de 10 microns, les couches formant les cinq premiers microns déposées sur le substrat sont des couches d'une épaisseur de 10 nm et les couches formant les cinq derniers microns de l'épaisseur totale du revêtement, sont des couches ayant une épaisseur de 100 nm.

Mais le revêtement de l'invention peut être également constitué d'un empilement de couches qui ont des épaisseurs augmentant progressivement, selon une progression linéaire ou autre, de 10 nm à 500 nm.

Le revêtement multicouche de l'invention représenté en figure 1 n'est pas déposé directement sur le substrat.

Il peut en effet, être nécessaire, selon la nature du substrat, de prévoir, entre le substrat 1 et le revêtement 6 selon l'invention, une couche intermédiaire, notée 2 en figure 1, en SiC:H, d'une épaisseur comprise 200 et 800 nm inclus, de préférence d'environ 400 nm, pour améliorer l'adhérence du revêtement 6 sur le substrat 1.

Le procédé de l'invention pour réaliser le revêtement de l'invention, consiste à déposer sur un support métallique, plastique ou céramique un empilement de couches en a-C:H strictement identiques, bien que leurs épaisseurs puissent différer, par dépôt chimique en phase vapeur assisté par plasma, communément appelé PECVD.

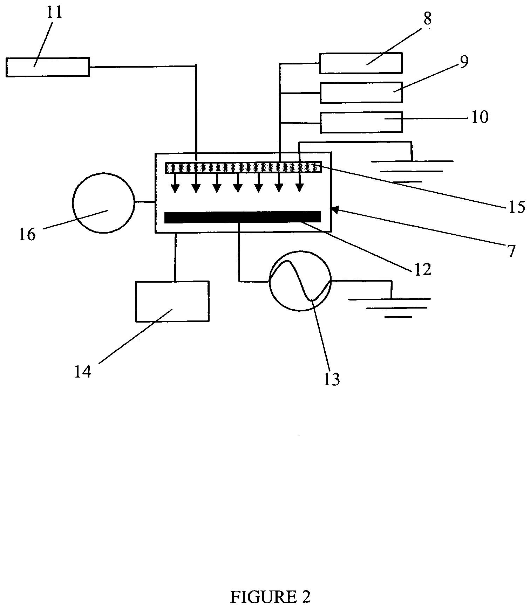

Une enceinte de PEVCD est représentée schématiquement en figure 2.

Comme on le voit en figure 2, l'enceinte de PEVCD, notée 7 en figure 2, est alimentée en azote par la canalisation notée 8 en figure 2, en hydrogène par la canalisation notée 9 en figure 2, et en argon par la canalisation notée 10 en figure 2. Le précurseur de carbone amorphe hydrogéné est, lui, introduit dans l'enceinte 7 par la canalisation d'alimentation notée 11 en figure 2.

L'enceinte 7 est maintenue sous vide par la pompe à vide notée 14 en figure 2. La pression dans l'enceinte 7 est contrôlée par la jauge notée 16 en figure 2. L'enceinte est alimentée par le générateur de puissance noté 13 en figure 2. A l'intérieur de l'enceinte 7, se trouve un porte-échantillon, noté 12 en figure 2, sur lequel on place le substrat 1 à revêtir. Une couche, notée 15 en figure 2, permet la vaporisation du précurseur carboné et des gaz argon, hydrogène et azote sur l'échantillon, non représenté en figure 2.

L'échantillon est déposé directement sur le porte-échantillon 12 correspondant à l'électrode polarisée. L'entrode entre la douche 15 et le porte-échantillon 12 est maintenue constante à 200 mm.

Ensuite, on introduit un mélange gazeux précurseur de carbone amorphe hydrogéné constitué de 80% en volume, par rapport au volume total du mélange, de C₆H₁₂ et de 20% de H₂.

La pression dans l'enceinte est maintenue entre 2 et 10 Pa. De préférence, elle est maintenue à 4 Pa.

La puissance appliquée à l'électrode (porte-échantillon 12) est de 320 W sous une tension de 670 V. Cette tension équivaut à une tension de polarisation.

Le revêtement 1 de l'invention est obtenu en créant des interfaces lors de l'élaboration d'un revêtement a-C:H standard. Les paramètres de dépôt sont donc strictement identiques pour toutes les couches déposées et sont les mêmes que pour l'élaboration d'un revêtement en carbone amorphe hydrogéné standard, à l'exception de la durée de chaque étape de dépôt qui peut varier selon l'épaisseur voulue de chaque couche

Les intervalles de temps sont avantageusement d'une durée inférieure à la durée de dépôt de la dernière couche élaborée.

Ceci signifie que lorsque la dernière couche élaborée est la couche formée à l'étape a), la durée d'arrêt du générateur sera inférieure à la durée de cette étape a) et que lorsque la dernière couche élaborée est une formée à l'étape c) ou à la répétition d'un étape c), la durée d'arrêt du générateur sera inférieure à la duré de cette dernière étape c) ou de répétition de l'étape c).

Quant à la durée de dépôt entre deux arrêts du générateur, elle est adaptée selon l'épaisseur que l'on souhaite obtenir pour la couche élémentaire considérée. Cette épaisseur est comprise entre 10 nm et 500 nm inclus.

Dans le cas d'un revêtement à couches d'épaisseur identique, lorsque le générateur est allumé à nouveau, on le laisse allumé pendant la même durée que pour le dépôt de la première couche et on l'arrête à nouveau pendant la même durée que lors du dépôt de la première couche. On répète cette manipulation, allumage du générateur et arrêt du générateur, autant de fois que nécessaire pour obtenir le revêtement de l'épaisseur voulue.

Dans le cas d'un revêtement à couches d'épaisseur variable, les temps de dépôt et d'arrêt seront adaptés en fonction des épaisseurs voulues.

La durée pendant laquelle le générateur est éteint correspond à la création d'une phase de transition entre deux couches de a-C:H. Il est important de multiplier le nombre d'interfaces afin de minimiser les contraintes. Avantageusement, il faut 10 couches par micromètre de revêtement. La durée de cette coupure doit être maintenue suffisamment faible pour ne pas créer de phénomène de pollution de surface.

Éventuellement, une étape de décapage, par exemple par bombardement ionique sous gaz neutre peut être réalisée pendant chaque interruption de dépôt afin d'améliorer la qualité des interfaces.

Ainsi, la création d'interfaces au sein d'un dépôt de DLC hydrogéné permet de réduire les contraintes résiduelles du revêtement 1. La réalisation de revêtement ayant des épaisseurs plus importantes que celles atteignables, sans apparition de contraintes résiduelles, avec les revêtements de l'art antérieur, qu'ils soient monocouches ou multicouches, est donc possible tout en maintenant des propriétés mécaniques et tribologiques intéressantes (dureté, module d'Young, coefficient de frottement et taux d'usure sensiblement identiques à un revêtement multicouches). Ainsi, la possibilité de maintenir un taux d'usure et un coefficient de frottement aussi bas que celui d'un DLC standard mais avec une épaisseur multipliée par 5 permet d'augmenter considérablement la durée de vie des pièces ainsi traitées.

Afin de mieux faire comprendre l'invention, on va maintenant en décrire, à titre purement illustratif et non limitatif, un exemple de mise en oeuvre.

### Exemple 1

La pièce à revêtir est une pièce en acier poli miroir d'un diamètre 50 mm.

Tout d'abord, la pièce est décapée, c'est-à-dire nettoyée chimiquement avec de l'acétone en utilisant un bain à ultra-sons et séchée à l'alcool, avant d'être disposée sur le porte-échantillon 12 dans l'enceinte 7 de PEVCD.

L'enceinte 7 est mise sous vide secondaire (jusqu'à environ 2 10⁻⁶ mbar) et un décapage ionique est effectué par injection d'un mélange gazeux constitué d'argon et d'hydrogène.

Dans cette étape de décapage, le débit d'argon est de 90 sccm, le débit d'hydrogène est de 90 sccm, la pression dans l'enceinte 7 est de 5 Pa. La puissance appliquée sur l'électrode de polarisation (porte-échantillon 12) est de 300 W et la tension de 300 V.

Cette étape de décapage dure 20 minutes.

Ensuite, on procède au dépôt d'une couche 2 de SiC:H d'une épaisseur de 400 nm sur le substrat 1.

Cette couche 2 est déposée de manière à obtenir et à optimiser l'adhérence du revêtement de l'invention sur l'échantillon.

On introduit alors du tetraméthylsilane à un débit de 125 sccm sous une pression de 10 Pa en appliquant une puissance de 100 W et une tension de 410 V sur l'électrode de polarisation (porte-échantillon 12).

Ensuite, le revêtement multicouches de l'invention est déposé. Les paramètres utilisés pour le dépôt de chaque couche constituant ce revêtement sont :
- débit C₆H₁₂ : 100 sccm,
- débit H₂ : 25 sccm,
- pression : 4 Pa,
- puissance : 320 W,
- tension : 670 V.

Chaque étape de dépôt dure 28 secondes pour obtenir une couche de 25 nm d'épaisseur.

Toutes les 28 secondes, le générateur est éteint pendant exactement 2 secondes pour créer l'interface.

80 couches sont ainsi déposées.

Les propriétés mécaniques du revêtement ainsi obtenu ont été étudiées et la comparaison avec celles d'un dépôt a-C:H classique sont reportées au tableau 1 ci-après :

**Tableau 1**

| | Dureté (GPa) | Module d'Young (Gpa) | Contraintes résiduelles (MPa) | Coefficient de Frottement | Taux d'usure (mm³N⁻¹m⁻¹) |
|---|---|---|---|---|---|
| Dépôt a-C:H classique monocouche (∼ 2 µm) | 19±2 | 142±10 | 1100± 100 | 0.04 ± 0.02 | 1,7 10⁻⁷ |
| Revêtement de l'invention a-C:H/a-C:H (∼ 2 µm) | 20 ± 2 | 159 ± 10 | 750 ± 100 | 0.05 ± 0.02 | 2,1 10⁻⁷ |

Les contraintes résiduelles ont été obtenues à partir de la formule de Stoney sur des clinquants en acier inoxydable de 0,1 mm d'épaisseur.

Les valeurs de coefficient de frottement et de taux d'usure indiquées au tableau 1 correspondent à celles obtenues à partir d'un test pion disque réalisé à température et humidité ambiante avec une bille d'alumine et une pression de Hertz d'environ 650 MPa pendant 100 000 cycles à 0,17m/s.

Ces valeurs ont été obtenues par les méthodes décrites dans S.J. Bull, Nanoindentation of coatings, J. Phys. D: Appl. Phys., 38 (2005) R393-R413.

Les applications industrielles de ce type de revêtement sont multiples. On peut citer l'ensemble des pièces de moteur qui sont soumises à des problèmes de frottements et d'usure importants. De plus, de par les propriétés diverses des DLC hydrogénés, c'est-à-dire leur grande inertie chimique, leurs propriétés électriques particulières ainsi que leur haemo- et bio-compatibilité, ces dépôts peuvent également s'appliquer aux domaines des implants chirurgicaux ainsi que des microsystèmes électromécaniques (MEMS).

## Revendications

1. Revêtement (6) en carbone amorphe hydrogéné sur au moins une surface d'un substrat (1) **caractérisé en ce qu'**il comprend au moins deux couches (3, 4) superposées l'une sur l'autre en carbone amorphe hydrogéné, chaque dite couche (3, 4) ayant des compositions chimiques et des caractéristiques physiques et mécaniques identiques, et des épaisseurs identiques ou différentes.

2. Revêtement (6) selon la revendication 1 **caractérisé en ce que** chaque dite couche (3, 4) en carbone amorphe hydrogéné a une épaisseur inférieure ou égale à 500 nm.

3. Revêtement (6) selon l'une quelconque des revendications précédentes **caractérisé en ce qu'**il a une épaisseur supérieure ou égale à 1,5 micromètres, de préférence supérieure ou égale à 2 micromètres.

4. Revêtement (6) selon l'une quelconque des revendications précédentes, **caractérisé en ce qu'**il comprend plus de dix couches par micromètre d'épaisseur de revêtement.

5. Procédé de dépôt d'un revêtement (6) selon l'une quelconque des revendications précédentes, sur au moins une surface d'un substrat (1) **caractérisé en ce qu'**il comprend les étapes suivantes :
a) dépôt par dépôt chimique en phase vapeur assisté par plasma d'une première couche (3) en carbone amorphe hydrogéné, pendant une durée t₁,
b) arrêt du générateur de plasma pendant une durée t,
c) dépôt d'une seconde couche (4) sur la couche (3) obtenue à l'étape a) par remise en route du générateur de plasma dans les mêmes conditions de puissance, de température, de pression et d'atmosphère qu'à l'étape a), pendant une durée t₂ qui est identique ou différente de la durée t₁ de l'étape a),
d) optionnellement, répétition au moins une fois des étapes b) et c) jusqu'à obtenir l'épaisseur voulue du revêtement (6).

6. Procédé selon la revendication 5, **caractérisé en ce que** la durée t d'arrêt du générateur plasma à l'étape b) est inférieure à la durée de chacune des étapes a) ou c) de dépôt.

7. Procédé selon la revendication 5 ou 6, **caractérisé en ce que** pendant l'étape b) d'arrêt du générateur, on réalise un décapage de la surface supérieure de la couche obtenue à l'étape précédente.

8. Procédé selon la revendication 7, **caractérisé en ce que** ledit décapage est réalisé par bombardement ionique sous gaz neutre de ladite surface supérieure.

9. Procédé selon l'une quelconque des revendications 5 à 8, **caractérisé en ce que** les durées t₁ et t₂ des étapes a) et c) sont telles que l'épaisseur de chaque dite couche (3, 4) est inférieure ou égale à 500 nm.

10. Procédé selon l'une quelconque des revendications 5 à 9 **caractérisé en ce que** les étapes b) et c) sont répétées jusqu'à obtenir une épaisseur finale de revêtement supérieure ou égale à 1,5 micromètres, de préférence supérieure ou égale 2 micromètres.

11. Procédé selon l'une quelconque des revendications 5 à 10, **caractérisé en ce qu'**il comprend de plus, avant l'étape a), une étape de dépôt d'une couche (2) en SiC:H sur ladite au moins une surface du substrat (1).

12. Dispositif comprenant un revêtement selon l'une quelconque des revendications 1 à 4 ou obtenu par le procédé selon l'une quelconque des revendications 5 à 11.

## Patentansprüche

1. Beschichtung (6) aus hydriertem amorphem Kohlenstoff auf mindestens einer Oberfläche eines Substrats (1), **dadurch gekennzeichnet, dass** sie mindestens zwei übereinander gelagerte Schichten (3, 4) aus hydriertem amorphem Kohlenstoff umfasst, wobei jede der Schichten (3, 4) identische chemische Zusammensetzungen und physikalische und mechanische Eigenschaften und identische oder verschiedene Dicken aufweist.

2. Beschichtung (6) nach Anspruch 1, **dadurch gekennzeichnet, dass** jede der Schichten (3, 4) aus hydriertem amorphem Kohlenstoff eine Dicke von weniger als oder gleich 500 nm aufweist.

3. Beschichtung (6) nach einem der vorhergehenden Ansprüche, **dadurch gekennzeichnet, dass** sie eine Dicke von mehr als oder gleich 1,5 Mikrometer, vorzugsweise von mehr als oder gleich 2 Mikrometer aufweist.

4. Beschichtung (6) nach einem der vorhergehenden Ansprüche, **dadurch gekennzeichnet, dass** sie mehr als zehn Schichten pro Mikrometer Dicke der Beschichtung umfasst.

5. Verfahren zur Ablage einer Beschichtung (6) nach einem der vorhergehenden Ansprüche auf mindestens einer Oberfläche eines Substrats (1), **dadurch gekennzeichnet, dass** es die folgenden Schritte umfasst:
a) Ablegen durch plasmaverstärkte chemische Dampfphasenablage einer ersten Schicht (3) aus hydriertem amorphem Kohlenstoff während einer Dauer t₁,
b) Stoppen des Plasmagenerators während einer Dauer t,
c) Ablegen einer zweiten Schicht (4) auf der Schicht (3), die in Schritt a) erhalten wurde, durch Wiedereinschalten des Plasmagenerators unter den gleichen Bedingungen von Leistung, Temperatur, Druck und Atmosphäre wie in Schritt a) während einer Dauer t₂, die identisch oder verschieden von der Dauer t₁ von Schritt a) ist,
d) optional mindestens einmal Wiederholen der Schritte b) und c), bis die gewünschte Dicke der Beschichtung (6) erhalten wird.

6. Verfahren nach Anspruch 5, **dadurch gekennzeichnet, dass** die Dauer t des Stopps des Plasmagenerators in Schritt b) geringer als die Dauer jedes der Schritte a) oder c) des Ablegens ist.

7. Verfahren nach Anspruch 5 oder 6, **dadurch gekennzeichnet, dass** während Schritt b) des Stoppens des Generators eine Abbeizung der oberen Fläche der Schicht, die im vorhergehenden Schritt erhalten wurde, durchgeführt wird.

8. Verfahren nach Anspruch 7, **dadurch gekennzeichnet, dass** die Abbeizung durch lonenbeschuss unter neutralem Gas der oberen Fläche durchgeführt wird.

9. Verfahren nach einem der Ansprüche 5 bis 8, **dadurch gekennzeichnet, dass** die Dauern t₁ und t₂ der Schritte a) und c) derart sind, dass die Dicke jeder der Schichten (3, 4) geringer als oder gleich wie 500 nm ist.

10. Verfahren nach einem der Ansprüche 5 bis 9, **dadurch gekennzeichnet, dass** die Schritte b) und c) wiederholt werden, bis eine endgültige Dicke der Beschichtung von mehr als oder gleich 1,5 Mikrometer, vorzugsweise von mehr als oder gleich 2 Mikrometer erhalten wird.

11. Verfahren nach einem der vorhergehenden Ansprüche 5 bis 10, **dadurch gekennzeichnet, dass** es außerdem, vor Schritt a), einen Schritt des Ablegens einer Schicht (2) aus SiC:H auf der mindestens einen Fläche des Substrats (1) umfasst.

12. Vorrichtung, umfassend eine Beschichtung nach einem der Ansprüche 1 bis 4 oder erhalten durch das Verfahren nach einem der Ansprüche 5 bis 11.

## Claims

1. Coating (6) of hydrogenated amorphous carbon on at least one surface of a substrate (1), **characterised in that** said coating comprises at least two layers (3, 4) of hydrogenated amorphous carbon superimposed on one another, each of said layers (3, 4) having identical chemical compositions and identical physical and mechanical characteristics, and identical or different thicknesses.

2. Coating (6) according to claim 1, **characterised in that** each of said layers (3, 4) of hydrogenated amorphous carbon has a thickness less than or equal to 500nm.

3. Coating (6) according to any of the previous claims, **characterised in that** said coating has a thickness greater than or equal to 1.5 micrometres, preferably greater than or equal to 2 micrometres.

4. Coating (6) according to any of the previous claims, **characterised in that** said coating comprises more than ten layers per micrometre of coating thickness.

5. Method for depositing a coating (6) according to any of the previous claims onto at least one surface of a substrate (1), **characterised in that** said method comprises the following steps:
a) depositing a first layer (3) of hydrogenated amorphous carbon via plasma-enhanced chemical vapour deposition, for a period of time t₁,
b) stopping the plasma generator for a period of time t,
c) depositing a second layer (4) onto the layer (3) obtained in step a) by restarting the plasma generator under the same power, temperature, pressure and atmosphere conditions as in step a), for a period of time t₂ that is identical to or different than the period of time t₁ of step a),
d) optionally, repeating steps b) and c) at least once until the desired thickness of the coating (6) is obtained.

6. Method according to claim 5, **characterised in that** the period of time t during which the plasma generator is stopped in step b) is less than the duration of each of depositing steps a) and c).

7. Method according to claim 5 or 6, **characterised in that** during step b) of stopping the generator, the upper surface of the layer obtained in the previous step is stripped.

8. Method according to claim 7, **characterised in that** said stripping is carried out via inert gas ion bombardment of said upper surface.

9. Method according to one of claims 5 to 8, **characterised in that** the period of times t₁ and t₂ of steps a) and c) are such that the thickness of each of said layers (3, 4) is less than or equal to 500nm.

10. Method according to one of claims 5 to 9, **characterised in that** steps b) and c) are repeated until an upper coating final thickness greater than or equal to 1.5 micrometres, and preferably greater than or equal to 2 micrometres, is obtained.

11. Method according to one of claims 5 to 10, **characterised in that** said method further comprises, before step a), a step of depositing a layer (2) of SiC:H onto said at least one surface of the substrate (1).

12. Device comprising a coating according to any of claims 1 to 4 or obtained by the method according to any of claims 5 to 11.
